Europäisches Patentamt

European Patent Office

Office européen des brevets

(19)

(11) **EP 1 368 668 B1**

(12) **EUROPÄISCHE PATENTSCHRIFT**

(45) Veröffentlichungstag und Bekanntmachung des Hinweises auf die Patenterteilung:
**21.07.2004 Patentblatt 2004/30**

(21) Anmeldenummer: **02716639.6**

(22) Anmeldetag: **06.03.2002**

(51) Int Cl.$^7$: **G01R 19/00**

(86) Internationale Anmeldenummer:
**PCT/DE2002/000808**

(87) Internationale Veröffentlichungsnummer:
**WO 2002/073221 (19.09.2002 Gazette 2002/38)**

(54) **MESSWERT-ERFASSUNGS- UND -VERARBEITUNGSEINHEIT FÜR KLEINE MESSSIGNALE**

MEASURED VALUE ACQUISITION AND PROCESSING UNIT FOR SMALL MEASURING SIGNALS

UNITE DE DETECTION ET DE TRAITEMENT DE VALEURS DE MESURE POUR PETITS SIGNAUX DE MESURE

(84) Benannte Vertragsstaaten:
**DE FR GB SE**

(30) Priorität: **14.03.2001 DE 10112304**

(43) Veröffentlichungstag der Anmeldung:
**10.12.2003 Patentblatt 2003/50**

(73) Patentinhaber: **SIEMENS AKTIENGESELLSCHAFT**
**80333 München (DE)**

(72) Erfinder:
• **NEUMANN, Siegfried**
  **92245 Kümmersbruck (DE)**
• **WINDSHEIMER, Klaus**
  **91174 Spalt (DE)**

(56) Entgegenhaltungen:
**DE-C- 3 700 368        GB-A- 1 575 148**
**US-A- 4 163 940        US-A- 5 929 628**

EP 1 368 668 B1

EP 1 368 668 B1

## Beschreibung

Die Erfindung bezieht sich auf eine Messwert-Erfassungs- und -Verarbeitungseinheit für kleine Signale, die durch einen Messkreis gebildet wird, der mindestens eine Abtasteinheit, einen A/D-Wandler und eine digitale Signalverarbeitung aufweist, wobei die Abtasteinheit zur Abtastung eines zu erfassenden Messsignals dient, der A/D-Wandler zu Digitalisierung der Abtastwerte vorgesehen ist und die digitale Signalverarbeitung zur Verarbeitung der digitalisierten Abtastwerte dient, die neben dem zu erfassenden Nutzwert aus dem Messsignal Störanteile als Folge von Störsignalen, z.B. Rauschen und Einkopplungen in den Messkreis, aufweisen können.

Ein klassisches Beispiel für die erforderliche genaue Erfassung von Messsignalen ist der elektronische Motorschutz, bei dem die Motorströme als Eingangsgrößen eines thermischen Motormodells dienen. Um die Variantenzahl von Motorschutzgeräten zu minimieren, wird ein Motorschutz mit hohem Einstellbereich von z.B. 1:10 gefordert, wobei dieser das Verhältnis von minimalen Nennstrom zu maximalen Nennstrom des Motors angibt. Darüber hinaus muss berücksichtigt werden, dass der Anlaufstrom des Motors das Zehnfache des Nennstroms betragen kann, so dass für den Analog/Digital-Wandlers ein Dynamikbereich von 1:100 erforderlich ist.

Außerdem muss im Betrieb über die Strommessung erfasst werden, ob der Motor ordnungsgemäß ein- oder ausgeschaltet ist. Nach praktischen Erfahrungen kann davon ausgegangen werden, dass im ausgeschalteten Zustand des Motors der gemessene Strom kleiner als 20 % des Motornennstroms ist. Dies erfordert eine Erhöhung des Dynamikbereichs auf 1:500.

Für die Erfassung des Stroms ist neben dem Analog/Digital-Wandler außerdem ein entsprechender Stromsensor erforderlich, der denselben Dynamikbereich abdecken muss. Darüber hinaus besteht die Forderung nach einem kostengünstigen Stromsensor, was sich mit einem kleinen Stromsensor mit kleinem Ausgangssignal erreichen lässt. Hierbei ergibt sich jedoch das Problem, dass derart kleine Ausgangssignale im Bereich von Störsignalen, z.B. Rauschen, Überkopplungen usw. liegen können, und dennoch eine Unterscheidung zwischen dem Motorstrom als eigentliches Nutzsignal und verfälschenden Störsignalen notwendig ist.

Patentschrift GB 1 575 148 (HELIOWATT WERKE) offenbart eine zum Stand der Technik gehörende Messwert-Erfassungs - und Verarbeitungseinheit.

Daher liegt der Erfindung die Aufgabe zugrunde, eine Messwert-Erfassungs- und -Verarbeitungseinheit der oben genannten Art zu schaffen, die kostengünstig einen großen Dynamikbereich bei der Erfassung von Messgrößen ermöglicht.

Die Aufgabe wird mit einer Messwert-Erfassungs- und -Verarbeitungseinheit mit den Merkmalen nach Anspruch 1 gelöst. Hierbei ist ein Schaltelement vorgesehen, durch welches eine elektrische Verbindung des Messkreises mit seinem Bezugspotential AGND herstellbar ist, bei der ohne Einkopplung eines Messsignals in den Messkreis ausschließlich etwa vorhandene Störsignale im Messkreis auftreten und durch diesen erfasst werden. Die digitale Signalverarbeitung dient außerdem zur numerischen Kompensation, bei der mit Störanteilen behaftete Nutzwerte des Messsignals mit zeitrelevant isoliert erfassten Störanteilen kompensiert werden.

Der besondere Vorteil dieser erfindungsgemäßen Messwert-Erfassungs- und -Verarbeitungseinheit besteht darin, dass auf einfache Weise die das Nutzsignal verfälschenden Störanteile isoliert gemessen werden. Finden beide Messungen, d.h. einerseits die Messung zur Erfassung des Nutzwertes und andererseits die zur Erfassung des Störanteils nahezu zeitgleich bzw. mit vernachlässigbaren kleinen Zeitabstand statt. so lässt sich der Störanteil im erfassten Nutzwert in der digitalen Signalverarbeitung kompensieren.

Zur Erfassung von Verbraucherströmen mit Drehstromanschluss, z.B. von Motorströmen, erweist es sich als besonders vorteilhaft, wenn die Abtasteinheit einen Multiplexer aufweist, der zur Abtastung im Zeitmultiplex dreier von Stromsensoren ausgeführter Messsignale dient.

Eine besonders vorteilhafte Ausführungsform besteht, wenn die Stromsensoren als Stromwandler ausgeführt sind, deren ausgangsseitige Messsignale auf gemeinsamen Bezugspotential liegen und wenn für die Ankopplung der Messsignale und des Bezugspotentials im Multiplexer vier Eingänge zur Verfügung stehen.

Weiterhin ist es vorteilhaft, wenn im Multiplexer das Schaltelement realisiert ist, dass die Kurzschlussverbindung im Messkreis zum Bezugspotential herstellt.

Ein Ausführungsbeispiel der Erfindung wird im folgenden anhand einer Zeichnung näher erläutert. Es zeigen:

FIG 1    eine erfindungsgemäße Messwert-Erfassungs- und -Verarbeitungseinheit zur Erfassung eines Messsignals und

FIG 2    eine weitere erfindungsgemäße Ausführung der Messwert-Erfassungs- und -Verarbeitungseinheit zur Erfassung mehrerer Messgrößen, z.B. den Strömen eines Motors.

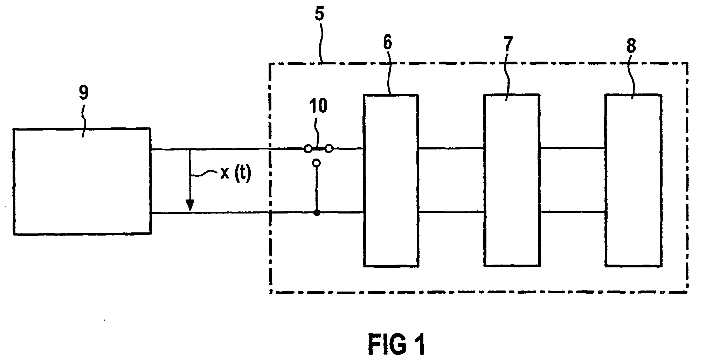

FIG 1 zeigt eine erfindungsgemäße Messwert-Erfassungs- und Verarbeitungseinheit 5. Diese wird durch einen Messkreis gebildet, der mindestens eine Abtasteinheit 6, einen Analog/Digital-Wandler 7 und eine digitale Signalverarbeitung 8 aufweist. Dabei dient die Abtasteinheit 6 zur Abtastung eines zu erfassenden sich zeitlich verändernden Messsignals x(t), das z.B. ein Strom, eine Spannung oder eine Temperatur sein kann und das von einem Sensor 9 zugeführt wird. Nach Digitalisierung der analogen Abtastwerte im Analog/Digital-Wandler 7 werden die digitalen Abtastwerte in der digitalen Signalverarbeitung 8 weiterverarbeitet. Die digitalen Abtastwerte können neben dem zu erfassenden Nutzwert aus dem Messsignal x(t) Störanteile als Folge von Störsignalen, z.B. Rauschen und Einkopplungen in den Messkreis enthalten. Um diese Störanteile isoliert zu erfassen, wird die Einkopplung des Messsignals x(t) durch Umschaltung des Schaltelements 10 aufgehoben, so dass im Messkreis ausschließlich etwa vorhandene Störsignale auftreten und durch diesen erfasst werden. Dabei ist zu beachten, dass die Störanteile zeitrelevant zu den erfassten Nutzwerten erfasst werden müssen, d.h. mit möglichst geringem zeitlichen Verzug. Was den Ort der Kurzschlussverbindung angeht, ist festzustellen, dass die Erfassung sämtlicher Störsignale umso umfassender und genauer ist, je näher die Schaltverbindung der Stelle liegt, an der das Messsignal x(t) in die Messwert-Erfassungs- und -Verarbeitungseinheit 5 eingekoppelt wird, z.B. zwischen den Eingangsklemmen für das Messsignal x(t).

Die digitale Signalverarbeitung 8 dient zur numerischen Kompensation, bei der mit Störanteilen behaftete Nutzwerte des Messsignals x(t) mit zeitrelevant isoliert erfassten Störanteilen kompensiert werden.

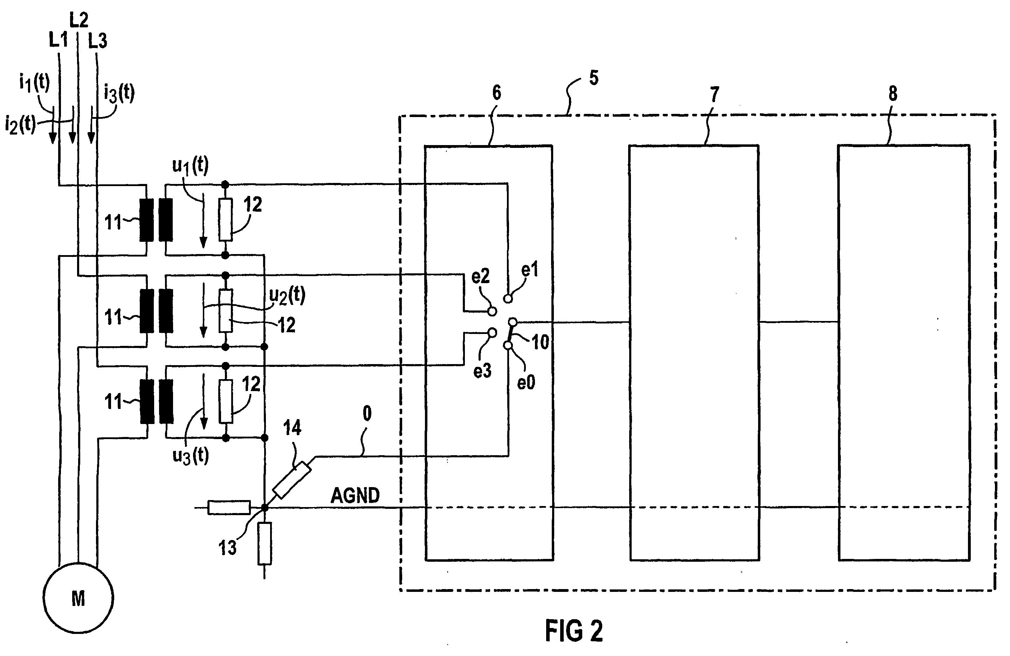

In FIG 2 ist eine weitere Ausführungsform einer erfindungsgemäßen Messwert-Erfassungs- und -Verarbeitungseinheit dargestellt. Hier wird zur Erfassung der thermischen Belastung eines Motors M die dreiphasige Strombelastung in den Phasenleitern L1, L2, L3 gemessen, in die Stromwandler 11 als Stromsensoren zwischengeschaltet sind, deren Sekundärwicklung mit einem Widerstand 12 beaufschlagt ist. An den drei Widerständen 12 liegt folglich eine dem jeweils erfassten Phasenstrom $i_1(t)$, $i_2(t)$, $i_3(t)$ proportionale Spannung $u_1(t)$, $u_2(t)$, $u_3(t)$ an, wobei mit t die Variable "Zeit" gekennzeichnet ist. Die drei Widerstände 12 sind im gemeinsamen Schaltungspunkt 13 zusammengeschaltet, der ein vorbestimmtes Bezugspotential, hier mit AGND bezeichnet, aufweist. Die gegenüber diesem Bezugspotential AGND an den Widerständen 12 anliegenden Spannungen $u_1(t)$, $u_2(t)$, $u_3(t)$ werden Eingängen einer Mess- und Verarbeitungseinheit 5 zugeführt. Diese umfasst einen Messkreis mit einem Multiplexer in einer Abtasteinheit 6, der Eingänge $e_1$, $e_2$, $e_3$, $e_0$ aufweist, einen Analog/Digital-Wandler 7 und eine digitale Signalverarbeitung 8. Über seine Eingänge $e_1$, $e_2$, $e_3$ greift der Multiplexer in einer vorbestimmten Multiplex-Reihenfolge, z.B. 1,2,3 die Spannungen $u_1(t)$, $u_2(t)$, $u_3(t)$ nacheinander ab. Es folgt dann die weitere Erfassung und Verarbeitung durch den Analog/Digital-Wandler 7 und die digitale Signalverarbeitung 8, wobei die gemeinsame Rückleitung des Messkreises an den Schaltungspunkt 13 mit dem Bezugspotential AGND gelegt ist. Im Multiplexer ist der weitere Eingang $e_0$ vorhanden, der wahlweise innerhalb oder außerhalb der Messwert-Erfassungs- und -Verarbeitungseinheit 5 über einen zusätzlichen Messkanal mit einem Widerstand 14 an das Bezugspotential AGND des Schaltungspunktes 13 angebunden ist. Der Widerstand 14 entspricht dem oben genannten als Bürde dienenden Widerstand 12.

Bei der erfindungsgemäßen Messwert-Erfassungs- und -Verarbeitungseinheit zur Erfassung der thermischen Belastung z.B. eines Motors wird von der Forderung ausgegangen, dass die Stromwandler 11 kostengünstig und dementsprechend klein sein müssen. Dies lässt sich durch Stromsensoren 11 mit entsprechend kleinen Messsignalen x(t) erreichen, die in ihrer Höhe im Bereich von Störsignalen, z.B. Rauschen, Überkopplung liegen. Dabei lassen sich Störsignale, die im Bereich der Stromsensoren 11 eingekoppelt werden, durch entsprechende Beschaltung mit geringem Aufwand kompensieren.

Die vorliegende Erfindung zielt darauf ab, die in der Messwert-Erfassungs- und -Verarbeitungseinheit 5 auftretenden eingekoppelten Störsignale zu kompensieren. Dabei wird davon ausgegangen, dass die Störsignale, mit denen die äquivalenten Strommesswerte $u_1(t)$, $u_2(t)$, $u_3(t)$ beaufschlagt sind, sich mit kleinem zeitlichen Versatz gesondert messen lassen, so dass mit einer numerischen Kompensation die für die Berechnung der thermischen Belastung erforderlichen genauen Nutzwerte unter Ausschluss von Störanteilen ermittelt werden können.

Zur Erfassung der gesonderten Störanteile $i_0$ dient der zusätzliche Eingang $e_0$, an den ein zusätzlicher Messkanal mit dem Widerstand 14 ausschließbar ist, der mit dem Bezugspotential AGND verbunden ist. In der oben genannten Multiplex-Reihenfolge 1,2,3 wird eine zusätzliche Phase 0, d.h. ein zusätzlicher Messkanal eingefügt. Durch den Multiplexer, d.h. sein Schaltelement 10, ist die Rückleitung mit dem Bezugspotential AGND über die Phase 0 mit dem Widerstand 14 mit dem Messkreis verbindbar. Dabei wird zugleich die Verbindung zu einem der Eingänge $e_1$, $e_2$, $e_3$ unterbrochen, so dass keine Messspannung $u_1(t)$, $u_2(t)$, $u_3(t)$ eingekoppelt wird, sondern im Messkreis ausschließlich Störsignale $i_0$ auftreten und erfasst werden.

Die jeweils in jeder der Phasen 1,2,3,0 erfassten Abtastwerte werden vom Multiplexer 6 an den Analog/Digital-Wandler 7 zur Digitalisierung weitergeleitet und schließlich in der digitalen Signalverarbeitung 8 weiterverarbeitet. Die digitale Signalverarbeitung 8 ist als Mikroprozessor ausgeführt, in dem. zur Ermittlung der thermischen Belastung die Effektivwerte der Phasenströme berechnet werden. Im Idealfall, d.h. ohne Auftreten von Störsignalen $i_0$ lässt sich mit einem digitalen Meßsystem zur Effektivwertmessung der Effektivwert in herkömmlicher Weise nach folgender Gleichung ermitteln

$$I_{RMS1} = \sqrt{\frac{1}{N} \cdot \sum_{n=1}^{N} i1[n]^2}$$

Im vorliegenden Fall unter Berücksichtigung des Einflusses von Störsignalen $i_0$ wird der Effektivwert des Stromes gemäß der Erfindung wie folgt ermittelt:

$$I_{RMS1} = \sqrt{\frac{1}{N} \cdot \left( \sum_{n=1}^{N} i1[n]^2 - \sum_{n=1}^{N} i0[n]^2 \right)}$$

Definition:

| $I_{RMS}$ | Effektivwert des Stromes |
|---|---|
| $I_{RMS1}$ | Effektivwert des Stromes in L1 |
| i[n] | digitaler Abtastwert an Ausgang des A/D-Wandlers |
| i1[n] | digitaler Abtastwert an Ausgang des A/D-Wandlers bei Multiplexerstellung L1 |
| i0[n] | digitaler Abtastwert an Ausgang des A/D-Wandlers bei Multiplexerstellung über Widerstand 14 auf Analog Ground |
| N | Anzahl der Abtastwerte für die Effektivwertberechnung |

## Patentansprüche

1.  Messwert-Erfassungs- und -Verarbeitungseinheit (5) für kleine Signale mit folgenden Merkmalen:

a) Die Messwert-Erfassungs- und -Verarbeitungseinheit (5) wird durch einen Messkreis gebildet, der mindestens eine Abtasteinheit (6), einen Analog/Digital-Wandler (7) und eine digitale Signalverarbeitung (8) aufweist,
b) die Abtasteinheit (6) dient zur Abtastung eines zu erfassenden Messsignals ($x(t)$, $u_1(t)$, $u_2(t)$, $u_3(t)$ ),
c) der Analog/Digital-Wandler (7) ist zur Digitalisierung der Abtastwerte vorgesehen,
d) die digitale Signalverarbeitung (8) dient zur Verarbeitung der digitalisierten Abtastwerte, die neben dem zu erfassenden Nutzwert aus dem Messsignal Störanteile als Folge von Störsignalen, z.B. Rauschen und Einkopplungen in den Messkreis, aufweisen können,
e) mit einem Schaltelement (10), durch welches eine elektrische Verbindung des Messkreises mit seinem Bezugspotential AGND herstellbar ist, bei der ohne Einkopplung eines Messsignals in den Messkreis ausschließlich etwa vorhandene Störsignale im Messkreis auftreten und durch diesen erfasst werden,
f) die digitale Signalverarbeitung (8) dient zur numerischen Kompensation, bei der die mit Störanteilen behafteten Nutzwerte des Messsignals mit zeitrelevant isoliert erfassten Störanteilen kompensiert werden, **dadurch gekennzeichnet, dass**,
g) die Messwert-Erfassungs- und Verarbeitungseinheit (5) bestimmt den Effektivwert $I_{RMS1}$ des Stromes $i_1(t)$, dem die proportionale Spannung $u_1(t)$ entspricht, nach der Formel

$$I_{RMS1} = \sqrt{\frac{1}{N} \cdot \left( \sum_{n=1}^{N} i1[n]^2 - \sum_{n=1}^{N} i0[n]^2 \right)}$$

mit den folgenden Definitionen:

| i1[n] | digitaler Abtastwert des Stromes $i_1(t)$ am Ausgang des Analog/Digital-Wandlers (7) |
|---|---|
| i0[n] | digitaler Abtastwert $i_1(t)$ am Ausgang des Analog/Digital-Wandlers (7) bei elektrischer Verbindung des Messkreises mit seinem Bezugspotential AGND |
| N | Anzahl der Abtastwerte für die Effektivwertberechnung |

2. Messwert-Erfassungs- und -Verarbeitungseinheit nach Anspruch 1, **dadurch gekennzeichnet, dass** die Abtasteinheit (6) einen Multiplexer aufweist, der zur Abtastung im Zeitmultiplex dreier von Stromsensoren (11) zugeführter Messsignale dient.

3. Messwert-Erfassungs- und -Verarbeitungseinheit nach Anspruch 2, **dadurch gekennzeichnet, dass** die Stromsensoren als Stromwandler (11) ausgeführt sind, deren ausgangsseitige Messsignale auf gemeinsamen Bezugspotential (AGND) liegen und dass für die Ankopplung der Messsignale und eines zusätzlichen Messkanals im Multiplexer vier Eingänge $e_0$, $e_1$, $e_2$, $e_3$ zur Verfügung stehen.

4. Messwert-Erfassungs- und -Verarbeitungseinheit nach einem der vorangehenden Ansprüche, **dadurch gekennzeichnet, dass** im Multiplexer das Schaltelement (10) realisiert ist, das die Kurzschlussverbindung im Messkreis zum Bezugspotential (AGND) herstellt.


**Revendications**

1. Unité (5) de détection et de traitement de valeurs de mesure pour de petits signaux qui a les caractéristiques suivantes :

   a) l'unité (5) de détection et de traitement de valeurs de mesure est formée d'un circuit de mesure, qui a au moins une unité (6) d'échantillonnage, un convertisseur (7) analogique/numérique et un traitement (8) numérique de signal,
   b) l'unité (6) d'échantillonnage sert à échantillonner un signal ($x(t)$, $u_1(t)$, $u_2(t)$, $u_3(t)$ de mesure à détecter,
   c) le convertisseur (7) analogique/numérique est prévu pour numériser les valeurs d'échantillonnage,
   d) le traitement (8) numérique du signal sert à traiter les valeurs numérisées d'échantillonnage qui peuvent comporter, outre la valeur utile à détecter, des composantes parasites provenant du signal de mesure en raison de signaux parasites, par exemple de bruits et d'injections par couplage dans le circuit de mesure,
   e) comprenant un élément (10) de commutation, par lequel une liaison électrique du circuit de mesure avec son potentiel AGND de référence peut être réalisée, dans laquelle, sans injection d'un signal de mesure dans le circuit de mesure, exclusivement des signaux parasites éventuellement présents se produisent dans le circuit de mesure et sont détectés par celui-ci,
   f) le traitement (8) numérique du signal sert à la compensation numérique dans laquelle les valeurs utiles du signal de mesure, entachées de parties parasites, sont compensées par des parties parasites détectées de manière isolée de façon pertinente dans le temps, **caractérisée en ce que**
   g) l'unité (5) de détection et de traitement des valeurs de mesure détermine la valeur $I_{RMS1}$ efficace du courant $i_1(t)$, à laquelle correspond la tension $u_1(t)$ proportionnelle suivant la formule

$$I_{RMS1} = \sqrt{\frac{1}{N} \cdot \left( \sum_{n=1}^{N} i1[n]^2 - \sum_{n=1}^{N} i0[n]^2 \right)}$$

   avec les définitions suivantes :

| i1[n] | Valeur numérique d'échantillonnage du courant $i_1(t)$ à la sortie du convertisseur (7) analogique/numérique |
|---|---|
| i0[n] | Valeur $i_1(t)$ numérique d'échantillonnage à la sortie du convertisseur (7) analogique/numérique lors d'une liaison électrique du circuit de mesure avec son potentiel AGND de référence |

(suite)

| N | Nombre des valeurs d'échantillonnage pour le calcul de la valeur efficace |
|---|---|

**2.** Unité de détection et de traitement de valeurs de mesure suivant la revendication 1, **caractérisée en ce que** l'unité (6) d'échantillonnage comporte un multiplexeur qui sert à l'échantillonnage en multiplexage dans le temps de trois signaux de mesure envoyés par des capteurs (11) de courant.

**3.** Unité de détection et de traitement de valeurs de mesure suivant la revendication 2, **caractérisée en ce que** les capteurs de courant sont réalisés en convertisseurs (11) de courant, dont les signaux de mesure en sortie sont à un potentiel (AGND) de référence commun, et **en ce que** quatre entrées $e_0$, $e_1$, $e_2$, $e_3$ sont disponibles pour le couplage des signaux de mesure et d'un canal de mesure supplémentaire dans le multiplexeur.

**4.** Unité de détection et de traitement de valeurs de mesure suivant l'une des revendications précédentes, **caractérisée en ce que** dans le multiplexeur est réalisé l'élément (10) de commutation, qui ménage la liaison de court-circuit dans le circuit de mesure vers le potentiel (AGND) de référence.

**Claims**

**1.** A measured value acquisition and processing unit (5) for small signals with the following features:

a) The measured value acquisition and processing unit (5) is formed by means of a measuring circuit which comprises at least a sampling unit (6), an analog/digital converter (7) and a digital signal processor (8),
b) the sampling unit (6) serves to sample a measuring signal ($x(t)$, $u_1(t)$, $u_2(t)$, $u_3(t)$) which is to be acquired,
c) the analog/digital converter (7) is provided for digitising the sampled values,
d) the digital signal processor (8) is used to process the digitised sampled values which, in addition to the useful value to be acquired from the measuring signal, may comprise interference components as a result of interference signals, e.g. noise and couplings into the measuring circuit,
e) a switching element (10) by means of which an electrical connection of the measuring circuit to its reference potential AGND can be established in which, without coupling of a measuring signal into the measuring circuit, only any interference signals present occur in the measuring circuit and are recorded by it,
f) the digital signal processor (8) is used for numeric compensation in which the useful values of the measuring signal which are affected by interference components are compensated using interference components acquired in isolation and in a time-relevant manner, **characterised in that**
g) the measured value acquisition and processing unit (5) determines the effective value $I_{RMS1}$ of the current $i_1(t)$ to which the proportional voltage $u_1(t)$ corresponds, according to the formula

$$I_{RMS1} = \sqrt{\frac{1}{N} \cdot \left( \sum_{n=1}^{N} i1[n]^2 - \sum_{n=1}^{N} i0[n]^2 \right)}$$

with the following definitions:

| i1[n] | Digital sampled value of the current $i_1(t)$ at the output of the analog/digital converter (7) |
|---|---|
| i0[n] | Digital sampled value $i_1(t)$ at the output of the analog/digital converter (7) with electrical connection of the measuring circuit to its reference potential AGND |
| N | Number of sampled values for the effective value calculation |

**2.** The measured value acquisition and processing unit according to claim 1, **characterised in that** the sampling unit (6) has a multiplexer which is used for sampling. three measuring signals supplied by current sensors (11) in time-division multiplex mode.

**3.** The measured value acquisition and processing unit according to claim 2, **characterised in that** the current sensors are implemented as current converters (11) whose output-side measuring signals are at common reference potential (AGND) and that four inputs e0, e1, e2, e3 are available for coupling the measuring signals and an additional measurement channel in the multiplexer.

4. The measured value acquisition and processing unit according to one of the preceding claims, **characterised in that** the switching element (10) which establishes the short-circuit connection to the reference potential (AGND) in the measuring circuit is implemented in the multiplexer.

$x(t)$

**FIG 1**

FIG 2